Europäisches Patentamt

**European Patent Office**

**Office européen des brevets**

(11) Numéro de publication: **0 176 448**
**A2**

(12)

# DEMANDE DE BREVET EUROPEEN

(21) Numéro de dépôt: 85401891.8

(22) Date de dépôt: 26.09.85

(51) Int. Cl.⁴: **H 04 B 9/00**
G 01 J 1/44, G 01 S 7/48
H 03 G 3/20

(30) Priorité: 28.09.84 FR 8414980

(43) Date de publication de la demande:
02.04.86 Bulletin 86/14

(84) Etats contractants désignés:
BE CH DE GB IT LI NL

(71) Demandeur: ELECTRICITE DE FRANCE Service National
2, rue Louis Murat
F-75008 Paris(FR)

(72) Inventeur: Gerardin, Jean-Pierre
2, Allée des Erables
F-92000 Nanterre(FR)

(74) Mandataire: Fort, Jacques et al,
CABINET PLASSERAUD 84, rue d'Amsterdam
F-75009 Paris(FR)

(54) Détecteur de faisceau lumineux à photodiode à circuit de réglage du point de fonctionnement.

(57) Le détecteur est destiné à recevoir un faisceau lumineux modulé à une fréquence qui constitue le paramètre significatif à mesurer. Il est notamment utilisable dans un appareil utilisant deux faisceaux de lumière cohérente provenant d'une même source, dont l'un est soumis au phénomène physique à étudier, qui affecte la fréquence, les deux faisceaux de lumière étant ensuite mélangés sur une photodiode à avalanche. Le détecteur comprend un circuit (28) de mesure du courant moyen traversant la photodiode à avalanche et des moyens (32) commandés par ce circuit et appliquant à la diode une tension de polarisation V telle que le courant moyen soit sensiblement égal à une valeur de consigne ajustable.

FIG.1.

0176448

<u>Détecteur de faisceau lumineux à photodiode à circuit de</u>
<u>réglage du point de fonctionnement</u>

L'invention concerne les détecteurs de faisceau lumineux modulé à une fréquence qui constitue le paramètre significatif à mesurer, du type utilisant comme capteur photoélectrique une photodiode à avalanche recevant le faisceau lumineux. L'invention trouve une application particulièrement importante dans les dispositifs détecteurs incorporés à des appareils utilisant deux faisceaux de lumière cohérente provenant d'une même source, dont l'un est soumis au phénomène physique à étudier, qui affecte la fréquence, les deux faisceaux de lumière étant ensuite mélangés sur le capteur constitué par la photodiode. L'intensité du faisceau modifié par le phénomène physique est en général faible devant celle de l'autre faisceau, dit "oscillateur local". L'intensité de cet autre faisceau a souvent le même ordre de grandeur que l'intensité de la source de lumière. La photodiode fournit un signal électrique ayant une composante à la fréquence de battement des deux faisceaux.

L'utilisation d'une photodiode à avalanche comme capteur soulève des problèmes. En particulier le point de fonctionnement nominal de la photodiode dépend non seulement de la tension électrique de polarisation, dont on est maître, mais aussi de l'intensité de lumière reçue, c'est-à-dire dans la pratique essentiellement de l'intensité du faisceau oscillateur local et de la température. La courbe représentant la caractéristique de fonctionnement de la photodiode dépend elle-même de ce point de fonctionnement et de ses paramètres. Or, le fonctionnement de la photodiode est optimal, notamment en ce qui concerne le rapport signal à bruit, lorsque la tension de polarisation est réglée à une valeur juste inférieure à celle qui provoque l'effet d'avalanche, c'est-à-dire est réglée à un point de la caractéristique situé juste avant le coude de celle-ci. Etant donné

2 0176448

qu'il faut éviter de dépasser ce coude de la caractéristique lors du fonctionnement en dépit des variations inévitables, on a jusqu'ici adopté un compromis consistant à régler la tension de polarisation à une valeur telle que l'on reste toujours en déçà de la zone d'avalanche.

Cette solution ne permet pas d'exploiter complètement les possibilités de la photodiode à avalanche, puisque la tension de polarisation sera telle que le point de fonctionnement nominal est nettement en dessous de la zone d'avalanche.

L'invention vise à fournir un détecteur de faisceau lumineux du type ci-dessus défini répondant mieux que ceux antérieurement connus aux exigences de la pratique, notamment en ce qu'il n'est plus soumis à la nécessité du compromis mentionné ci-dessus.

Pour cela, l'invention utilise le fait que bien souvent le paramètre caractéristique à mesurer n'est pas l'énergie lumineuse reçue par la photodiode mais la fréquence de modulation du faisceau et qu'en conséquence l'absence d'une loi de proportionnalité entre énergie lumineuse reçue et intensité du signal fourni par le capteur est sans inconvénient. Elle propose en conséquence un détecteur du type ci-dessus défini comprenant un circuit de mesure du courant moyen traversant la photodiode à avalanche et des moyens commandés par ledit circuit et appliquant à la diode une tension de polarisation telle que ledit courant moyen soit sensiblement égal à une valeur de consigne ajustable.

Cette valeur de consigne pourra être déterminée expérimentalement du fait que l'effet d'avalanche se traduit par l'apparition d'un courant inverse dans la photodiode, courant présentant une montée rapide.

On peut ainsi obtenir un rapport signal à bruit qui est pratiquement le meilleur possible.

Un limiteur est avantageusement prévu sur les moyens commandés par le circuit de mesure de façon à éviter de donner à la tension de polarisation une valeur incompatible avec la tenue de longue durée de la photodiode à avalanche.

L'invention sera mieux comprise à la lecture de la description qui suit de modes particuliers d'exécution donnés à titre d'exemples non limitatifs. La description se réfère au dessin qui l'accompagne, dans lequel :

- la Figure 1 est un schéma synoptique du dispositif ;

- la Figure 2 est un schéma électrique d'une boucle de réglage particulière pour un tel dispositif.

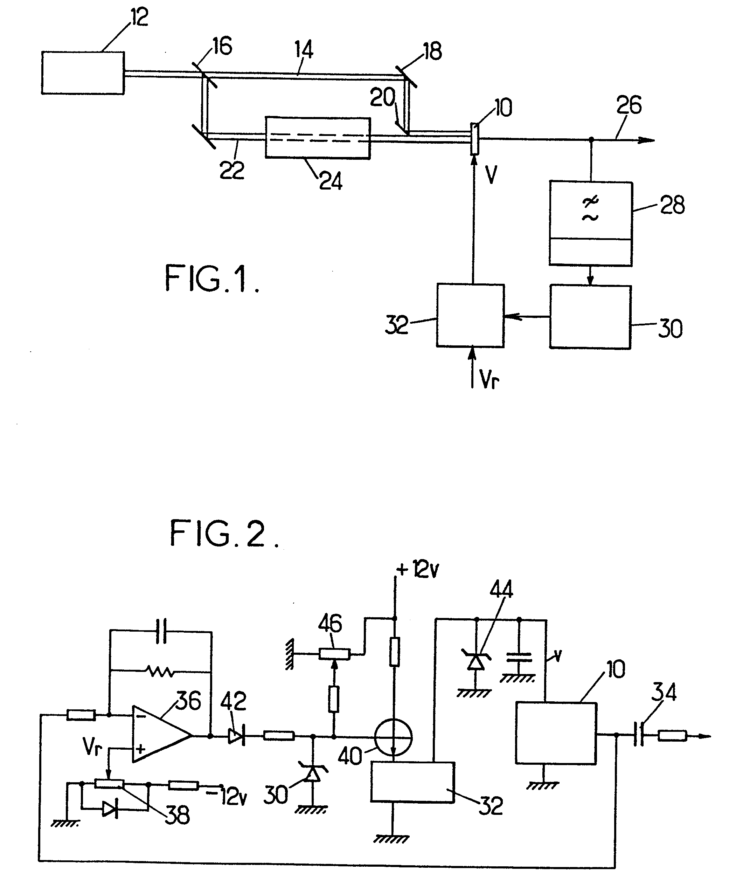

Le dispositif montré schématiquement sur la Figure 1 constitue un détecteur de faisceau lumineux hétérodyné. Ce détecteur comporte un capteur photoélectrique constitué par une photodiode à avalanche 10 qui reçoit le faisceau. Ce dernier est constitué par la superposition de deux composantes provenant l'une et l'autre d'une source de lumière cohérente 12, qui sera généralement un laser. La première composante, que l'on peut considérer comme un oscillateur local, transporte la presque totalité de l'énergie reçue par la photodiode 10. Sur la Figure 1, cette composante 14 est envoyée sur la photodiode 10 à partir du laser 12 par une lame semi-réfléchissante 16 et des miroirs 18 et 20. L'énergie apportée à la photodiode 10 par cette composante dépend évidemment de l'intensité du faisceau fourni par le laser 12 et de l'absorption subie sur le trajet.

La seconde composante 22 est soumise, en 24, à l'action d'un phénomène physique qui affecte la fréquence de la composante. Cette dernière transporte une énergie faible, souvent inférieure de plusieurs ordres de grandeur à l'énergie de l'oscillateur local.

Les deux composantes sont mélangées sur la surface sensible de la photodiode 10 qui fournit en

4    0176448

réponse, sur une sortie 26, un signal faisant apparaître une fréquence égale à la fréquence de battement des deux composantes 14 et 22.

Le détecteur comporte un circuit de réglage du point de fonctionnement de la photodiode 10. Ce circuit est constitué par une boucle agissant sur la tension de polarisation V appliquée à la photodiode 10. La boucle de réglage peut être regardée comme comportant un circuit de mesure du courant moyen traversant la photodiode et des moyens de réglage de la tension de polarisation V.

Le circuit 28 de mesure du courant moyen comporte un filtre passe-bas ayant une fréquence de coupure de quelques Hz, et un intégrateur. Le courant de sortie du circuit 28 est appliqué, dans le mode de réalisation représenté, à un limiteur 30 de protection, qui transmet le courant qu'il reçoit du circuit 28 dans la mesure où il ne dépasse pas une valeur déterminée, pouvant être ajustable, correspondant à la tension de polarisation maximale acceptable pour la photodiode 10. Le courant de sortie du limiteur 30, constituant signal de commande, est appliqué à un dispositif 32 de réglage de la tension de polarisation. Ce dispositif comprend un comparateur auquel sont appliqués le signal de commande provenant du limiteur 30 et un signal de référence ajustable $V_r$ choisi en fonction de la valeur de consigne du courant moyen traversant la photodiode 10.

Les circuits 28, 30 et 32 peuvent être constitués en composants classiques. La Figure 2 montre une réalisation de la boucle de réglage utilisable avec une photodiode à avalanche sur silicium, à large bande passante, comportant un préamplificateur incorporé fournissant une tension de sortie proportionnelle au courant dans la photodiode. Les composants de la boucle de la Figure 2 ont une disposition différente de celle de la Figure 1 mais procurent un résultat éqivalent. Ceux de ces composants qui correspondent à ceux de la Figure 1 portent le même numéro de référence.

La tension de sortie de la diode 10 est prélevée à travers un condensateur 34 pour être exploitée en tant que signal de mesure. Cette tension est directement appliquée à l'une des entrées d'un amplificateur différentiel d'asservissement 36 monté en intégrateur. L'autre entrée de l'amplificateur 36 reçoit la tension de référence Vr représentant la valeur de consigne du courant moyen traversant la diode, ajustable à l'aide d'un potentiomètre 38.

Les moyens de réglage de la tension de polarisation V comprennent un convertisseur continu/continu haute tension 32 et un transistor 40 de commande de la tension d'alimentation du convertisseur 32. Le signal de sortie de l'amplificateur différentiel 36 est appliqué à la base du transistor 40 par l'intermédiaire d'une diode 42. Une diode zener 30 constitue un limiteur d'entrée destiné à éviter que la tension d'entrée du convertisseur 32 ne dépasse une valeur pour laquelle la tension de sortie serait excessive pour la photodiode 10. Une seconde diode zener 44, placée à la sortie du convertisseur 32, assure une sécurité supplémentaire.

Pour maintenir la photodiode 10 en état de fonctionnement, il est nécessaire que sa tension de polarisation ait une valeur minimum. L'amplificateur 36 risque, en cas d'accroissement intense du flux lumineux reçu par la photodiode, d'abaisser la tension au-dessous de ce minimum. Pour permettre le fonctionnement dans ce cas, la boucle comporte un élément permettant de maintenir la tension de polarisation au-dessus du minimum. Dans le cas montré en Figure 2, cet élément est constitué par un potentiomètre 46 relié à la base du transistor 40.

A titre d'exemple, on peut indiquer qu'une boucle de régulation du type montré en Figure 2 a été appliquée à une photodiode C 30950 de la société RCA, comportant un préamplificateur incorporé et fournissant une tension proportionnelle au courant diode. Le convertisseur continu/continu était de type PF 1041 P de RCA, assurant la proportionalité entre tensions d'entrée et de sortie. Les diodes zener 30 et 44 limitaient respectivement les tensions appliquées à 4 Volts et 480 Volts.

REVENDICATIONS

1. Détecteur de faisceau lumineux modulé à une fréquence qui constitue le paramètre significatif à mesurer, utilisant comme capteur photoélectrique une photodiode à avalanche (10) recevant le faisceau lumineux, caractérisé en ce qu'il comprend un circuit (28) de mesure du courant moyen traversant la photodiode à avalanche et des moyens (32) commandés par ledit circuit (28) et appliquant à la photodiode une tension de polarisation telle que ledit courant moyen soit sensiblement égal à une valeur de consigne ajustable.

2. Détecteur selon la revendication 1, caractérisé en ce que les moyens commandés par ledit circuit comportent également au moins un limiteur (30,44) prévu pour éviter de donner à la tension de polarisation (V) une valeur incompatible avec la teneur à long terme de la photodiode.

3. Détecteur selon la revendication 1 ou 2, caractérisé en ce que le circuit (28) de mesure du courant moyen comprend un filtre passe-bas ayant une fréquence de coupure de quelques Hertz.

4. Détecteur selon la revendication 1 ou 2, caractérisé en ce que le circuit (28) de mesure de courant moyen comprend un amplificateur différentiel intégrateur recevant le signal de sortie de la photodiode et une tension de référence représentant la valeur de consigne et les moyens commandés (32) comportent un convertisseur continu/continu dont la tension d'entrée est fournie par un circuit à transistor commandé par l'amplificateur différentiel.

5. Détecteur selon la revendication 4, caractérisé en ce que le convertisseur est muni de moyens de réglage (46) lui imposant une tension de sortie minimale.

6. Détecteur selon l'une quelconque des revendications 1 à 5, caractérisé en ce que le faisceau lumineux provient de la juxtaposition de deux composantes provenant d'une même source (12) de lumière cohérente, dont l'une est soumise à un phénomène physique à étudier qui affecte la fréquence et présente une intensité beaucoup plus faible que celle de l'autre composante.

1/1

0176448

FIG.1.

FIG.2.